# DEMANDE DE BREVET EUROPEEN

(11) **EP 3 836 398 A1**
(43) Date de publication de la demande: **16.06.2021**
(21) Numéro de dépôt: 20210375.0
(22) Date de dépôt: 27.11.2020
(51) Int. Cl.: H03K 17/06

(54) **DISPOSITIF DE COMMANDE D'INTERRUPTEUR**

(30) Priorité: 12.12.2019 FR 1914293
(71) Demandeur: Commissariat à l'Energie Atomique et aux Energies Alternatives, 75015 Paris (FR)
(72) Inventeur: BERGOGNE, Dominique, 38054 GRENOBLE CEDEX 9 (FR); REGIS, Guillaume, 38054 GRENOBLE CEDEX 9 (FR)
(74) Mandataire: Cabinet Beaumont

(57) **Abrégé**

La présente description concerne un dispositif (200) comprenant un premier interrupteur (Tl), une diode (D220) et un élément résistif passif (R230) électriquement en série entre des bornes de conduction (D1) et de commande (G1) du premier interrupteur, une borne (222) de la diode située du côté du premier interrupteur étant reliée à un nœud (240 ; 256) d'application d'un potentiel variable par rapport au potentiel de ladite borne de conduction.

## Description

### Domaine technique

La présente description concerne de façon générale les dispositifs électroniques, en particulier la commande d'interrupteurs, plus particulièrement la commande d'interrupteurs de convertisseurs à découpage.

### Technique antérieure

Des interrupteurs commandés sont utilisés en particulier dans des convertisseurs à découpage. Les interrupteurs sont mis alternativement aux états passant et bloqué à une fréquence de découpage. On utilise des convertisseurs à découpage pour fournir une tension et/ou un courant, à partir d'une alimentation ayant des valeurs de tension/courant différentes des valeurs des tension/courant à fournir. Par exemple, un convertisseur à découpage de type alternatif-continu AC-DC (en anglais "Alternating current-Direct current") permet d'obtenir une tension continue à partir d'une tension alternative telle que celle d'un réseau électrique ou d'un alternateur. D'autres interrupteurs commandés sont utilisés dans divers circuits logiques, tels que des inverseurs.

De tels interrupteurs commandés comprennent typiquement des transistors à effet de champ. Dans certaines applications, les transistors sont de type dit transistor à haute mobilité électronique HEMT (en anglais "High Electron Mobility Transistor"), c'est-à-dire réalisant une conduction entre drain et source par une interface entre semiconducteurs à grande largeur de bande interdite (en anglais "wide bandgap"), les électrons étant mobiles le long de ladite interface. Ces semiconducteurs peuvent être du nitrure de Gallium GaN et du nitrure d'aluminium-gallium AlGaN. On parle alors de transistor de type HEMT à GaN.

Le document US 2004/136212 décrit un élévateur de tension ayant une structure réduisant le bruit.

Le document US 2007/0195556 décrit un circuit de commande pour dispositif de communication de puissance.

Le document US 2013/0088378 décrit un circuit de commutation de génération d'un signal impulsionnel radiofréquence, un circuit de génération d'un signal impulsionnel radiofréquence, et un appareil détectant des objets cibles.

Le document EP 0 055 941 décrit un convertisseur continu-alternatif capable de fonctionne à hautes fréquences.

Le document US 2006/0132194 décrit un circuit et procédé de commande d'un MOSFET de puissance.

Le document US 2013/214824 décrit un circuit de commande.

### Résumé de l'invention

Il existe un besoin d'améliorer les dispositifs connus de commande d'interrupteurs, en particulier les dispositifs connus de commande d'un interrupteur comprenant un transistor de type HEMT.

Un mode de réalisation pallie tout ou partie des inconvénients des dispositifs connus de commande d'interrupteur.

Un mode de réalisation prévoit un dispositif de commande d'interrupteur plus facile à mettre en œuvre que les dispositifs connus de commande d'interrupteur.

Un mode de réalisation prévoit un dispositif de commande d'interrupteur, ce dispositif pouvant être alimenté par un niveau de potentiel inadapté à une application directe à l'interrupteur pour commander l'interrupteur.

Un mode de réalisation prévoit un dispositif de commande dans lequel tous les interrupteurs sont constitués de transistors de type HEMT.

Un mode de réalisation pallie tout ou partie des inconvénients des circuits logiques connus, en particulier des inverseurs connus.

Un mode de réalisation prévoit un circuit logique, en particulier un inverseur, dans lequel tous les interrupteurs sont constitués de transistors de type HEMT.

Un mode de réalisation prévoit un dispositif comprenant un premier interrupteur, une diode et un élément résistif passif électriquement en série entre des bornes de conduction et de commande du premier interrupteur, une borne de la diode située du côté du premier interrupteur étant reliée à un nœud d'application d'un potentiel variable par rapport au potentiel de ladite borne de conduction.

Selon un mode de réalisation, ladite borne de la diode et ledit nœud sont reliés par un élément capacitif.

Plus particulièrement, un mode de réalisation prévoit un dispositif comprenant un premier interrupteur formé d'un transistor à effet de champ, une diode et un premier élément résistif passif électriquement en série entre un drain et une grille du premier interrupteur, ledit drain et une anode de la diode étant connectés à une borne d'application d'un premier potentiel d'une tension d'alimentation (VCC) référencée à un deuxième potentiel, et une cathode de la diode située du côté du premier interrupteur étant reliée, par un élément capacitif, à un nœud d'application d'un potentiel variable par rapport audit premier potentiel et supérieur audit deuxième potentiel.

Selon un mode de réalisation, ledit potentiel variable correspond à un signal en créneaux variant entre les premier et deuxième potentiels.

Selon un mode de réalisation, le premier interrupteur est de type HEMT, de préférence à GaN.

Selon un mode de réalisation, le premier élément résistif est situé entre ladite cathode de la diode et ladite grille.

Selon un mode de réalisation, le dispositif comprend, en outre, en série avec le premier interrupteur, un interrupteur supplémentaire, de préférence de type HEMT.

Selon un mode de réalisation, dans lequel un premier état (REF) du potentiel variable engendre l'application, à ladite borne de commande, un potentiel de blocage du premier interrupteur.

Selon un mode de réalisation, dans lequel,, à des premières périodes de non application du potentiel de blocage, ledit potentiel variable est à un niveau engendrant une mise à l'état passant du premier interrupteur.

Selon un mode de réalisation, dans lequel le potentiel variable est à un niveau de blocage du premier interrupteur pendant des deuxièmes périodes d'application du potentiel de blocage et pendant des troisièmes périodes situées au début et à la fin de chaque première période.

Selon un mode de réalisation, le dispositif comprend un inverseur reliant ledit nœud à une borne de commande d'un deuxième interrupteur configuré pour appliquer le potentiel de blocage à la borne de commande du premier interrupteur, le deuxième interrupteur étant de préférence de type HEMT.

Selon un mode de réalisation, l'inverseur comprend un autre élément résistif passif et un troisième interrupteur en série, une entrée reliée à la grille du troisième interrupteur, et une sortie reliée à un nœud de connexion entre ledit transistor et ledit autre élément résistif, le troisième interrupteur étant de préférence de type HEMT.

Selon un mode de réalisation, le dispositif comporte une deuxième résistance en série avec ladite diode (D220) entre ladite borne d'application du premier potentiel et un nœud entre le premier élément résistif et ledit élément capacitif.

Un mode de réalisation prévoit un inverseur comprenant un dispositif tel que défini ci-dessus.

Selon un mode de réalisation, l'inverseur d'un dispositif tel que décrit ci-dessus est un inverseur comprenant un dispositif tel que décrit ci-dessus.

Un mode de réalisation prévoit un circuit de commande d'un interrupteur commandé, comprenant un dispositif tel que défini ci-dessus, ledit interrupteur commandé comprenant, de préférence, un ou des transistors de type HEMT.

Un mode de réalisation prévoit un circuit monolithique comprenant un dispositif tel que défini ci-dessus, ou comprenant un circuit tel que défini ci-dessus comprenant, de préférence, ledit interrupteur commandé.

Un mode de réalisation prévoit un convertisseur à découpage comprenant un ou plusieurs dispositifs tels que définis ci-dessus ou un circuit tel que défini ci-dessus.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente, de manière très schématique, une cellule de commutation d'un convertisseur d'un type auquel s'appliquent les modes de réalisation décrits ;
la figure 2 représente, de manière très schématique, un mode de réalisation d'un dispositif de commande d'un interrupteur, et l'interrupteur commandé par le dispositif ;
la figure 3 représente, de manière schématique, un exemple de mode de réalisation du dispositif de commande de la figure 2 ;
la figure 4 représente, de manière très schématique, un mode de réalisation d'un inverseur ;
la figure 5 représente, de manière très schématique, un autre mode de réalisation du circuit de commande la figure 2 ; et
la figure 6 représente, par des chronogrammes schématiques, le fonctionnement du dispositif de la figure 5.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les structures de convertisseur et les procédés de génération de signaux de commande d'interrupteurs de convertisseur à découpage, ne sont pas décrits en détails, les modes de réalisation étant compatibles avec tous ou la plupart des convertisseurs à découpage usuels.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

Sauf précision contraire, les adjectifs numéraux ordinaux, tels que "premier", "deuxième", etc., sont utilisés seulement pour distinguer des éléments entre eux. En particulier, ces adjectifs ne limitent pas les dispositifs et procédés décrits à un ordre particulier de ces éléments.

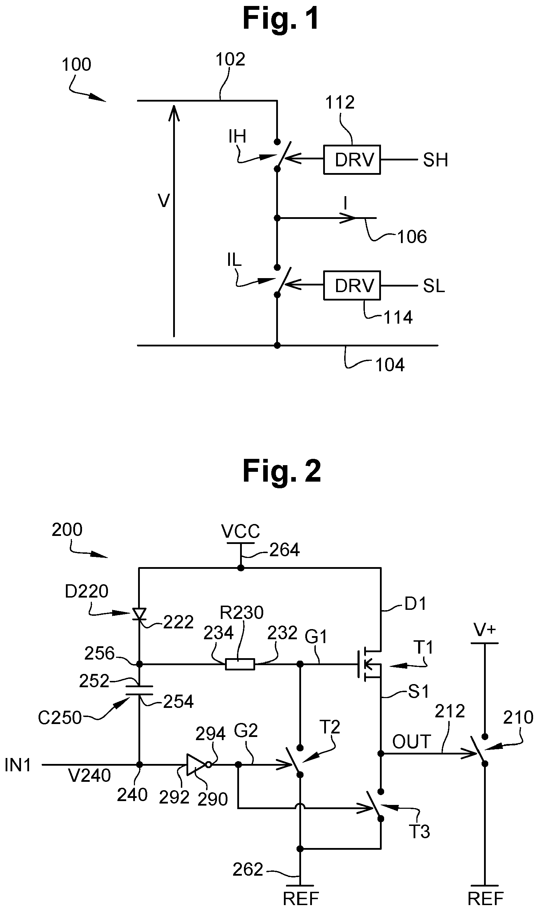

La figure 1 représente, de manière schématique, une cellule de commutation d'un convertisseur d'un type auquel s'appliquent les modes de réalisation décrits.

Une cellule de commutation est définie par l'association de deux interrupteurs IH et IL électriquement en série entre des nœuds 102 et 104. De préférence, les interrupteurs IH et IL sont de type HEMT. Par interrupteur de type HEMT, on entend que l'interrupteur comprend, ou est constitué par, un transistor de type HEMT, de préférence à GaN, ou plusieurs transistors de type HEMT, de préférence à GaN, en série et/ou en parallèle. Des transistors HEMT permettent de bloquer des tensions plus élevées et permettent des commutations plus rapides que d'autres types de transistors à effet de champ.

De préférence, les transistors compris dans, ou constituant, les interrupteurs IL et IH lorsque ceux-ci sont de type HEMT sont à enrichissement (en anglais "enhancement mode HEMT"). Les interrupteurs IL et IH sont alors également de type dit HEMT à enrichissement. Ces interrupteurs ou transistors sont alors de type dit normalement ouvert ou bloqué (en anglais "normally OFF"), c'est-à-dire non passant en l'absence de tension de commande (tension grille-source). En variante, le ou les transistors compris dans, ou constituant, l'un et/ou l'autre des interrupteurs IL et IH de type HEMT peuvent également être à appauvrissement ou à déplétion (en anglais "depletion mode HEMT"). L'interrupteur concerné est alors également de type dit HEMT à appauvrissement ou à déplétion. Ces interrupteurs ou transistors sont alors de type dit normalement fermé ou passant (en anglais "normally ON"), c'est-à-dire passant en l'absence de tension de commande (autrement dit, à tension de commande nulle) .

Des signaux SH et SL de commande des interrupteurs respectifs IH et IL sont appliqués aux interrupteurs respectifs IH et IL par des circuits, respectivement 112 et 114, d'attaque (DRV - en anglais "driver"), ou circuits de commande ou contrôle, de grille de transistor. Les signaux SH et SL sont de sorte que, lorsque l'un des interrupteurs IH et IL est passant, l'autre des interrupteurs est bloqué. Ainsi, les interrupteurs IH et IL ne sont pas passants simultanément. Les interrupteurs IH et IL peuvent aussi être bloqués simultanément.

Le convertisseur dans lequel se trouve la cellule de commutation 100 reçoit ou fournit une tension V. Le convertisseur reçoit ou fournit un courant I sur un noeud 106 de connexion en série des interrupteurs IH et IL. Le courant I est reçu ou fourni par des éléments non représentés du convertisseur. Le courant I est par exemple le courant dans une inductance, non représentée, interne au convertisseur. La structure du convertisseur n'est pas détaillée ici, les modes de réalisation décrits étant compatibles avec les convertisseurs à découpage usuels et les commandes usuelles d'interrupteurs de convertisseur à découpage.

Dans une application typique, la tension V est une tension alternative provenant d'un réseau de distribution électrique, et a, par exemple, une tension efficace de l'ordre d'environ 110 V ou d'environ 230 V, et par exemple une fréquence égale à 50 Hz ou 60 Hz. Le convertisseur fournit une tension continue, obtenue à partir du courant I par des parties non représentées du convertisseur. La tension continue est typiquement utilisée pour charger une batterie, par exemple une batterie d'un ordinateur portable ou d'un dispositif mobile de communication à distance tel qu'un téléphone mobile. Plus particulièrement, la charge de la batterie peut être réalisée par l'intermédiaire d'une connexion de type bus universel en série USB (en anglais "Universal-Serial-Bus") de préférence à fourniture de puissance (en anglais "Power-Delivery").

Les signaux de commande SH et SL sont typiquement en créneaux. Par signal en créneaux, on entend un signal comprenant une succession de cycles, chaque cycle comprenant une partie à un niveau bas du signal et une partie à un niveau haut du signal. Les cycles des signaux SH et SL sont répétés à une fréquence de découpage. Ainsi, à la fréquence de découpage, on rend alternativement l'interrupteur IH passant et l'interrupteur IL bloqué, puis l'interrupteur IL passant et l'interrupteur IH bloqué. Les procédés de génération des signaux des interrupteurs pour obtenir le fonctionnement souhaité du convertisseur ne sont pas décrits en détails, les modes de réalisation décrits étant compatibles avec les procédés usuels de génération de tels signaux.

Les modes de réalisation décrits sont applicables à tout convertisseur à découpage. En particulier, le convertisseur peut fournir et/ou recevoir une tension alternative monophasée ou multiphasée. Les modes de réalisation décrits sont également applicables à tout convertisseur comprenant, entre deux noeuds d'application d'une tension par exemple alternative ou d'application d'une phase d'une tension alternative multiphasée, une ou plusieurs branches en parallèle chacune constituée d'une cellule de commutation comprenant au moins deux interrupteurs en série. Ainsi, le convertisseur peut fournir une tension, par exemple alternative multiphasée, à un moteur.

La figure 2 représente, de manière très schématique, un mode de réalisation d'un dispositif de commande 200 d'un interrupteur 210, et l'interrupteur 210 commandé par le dispositif 200. Le dispositif 200, ou circuit 200, est typiquement destiné, dans un convertisseur comprenant une ou plusieurs cellules de commutation du type de la cellule 100 de la figure 1, à remplacer l'un et/ou l'autre des circuits 112 et 114 (figure 1). L'interrupteur 210 peut alors constituer l'un ou l'autre des interrupteurs IH ou IL de la cellule de commutation 100 de la figure 1.

Le dispositif 200 comprend un premier interrupteur, T1. De préférence, le premier interrupteur T1 comprend, par exemple est constitué par, un transistor à effet de champ, à canal N dans l'exemple représenté. Le transistor a alors des bornes de drain D1, de source S1 et de grille G1. Les bornes de drain et de source d'un tel interrupteur constituent des bornes de conduction de l'interrupteur, c'est-à-dire des bornes entre lesquelles l'interrupteur établit une connexion électrique lorsque celui-ci est à son état passant, et entre lesquelles l'interrupteur forme une isolation électrique lorsque celui-ci est à son état bloqué. La grille constitue une borne de commande de cet interrupteur. Plus préférentiellement, l'interrupteur T1 est type HEMT. Plus généralement, l'interrupteur T1 peut être de tout type usuel d'interrupteur ayant des bornes de conduction D1 et S1 et une borne de commande G1, et dont l'état passant/bloqué est commandé par une tension entre la borne de commande G1 et la borne de conduction S1. De préférence, l'interrupteur T1 est de type normalement bloqué. Dans le présent mode de réalisation, la borne de conduction S1 de l'interrupteur T1 correspond à une sortie du dispositif 200. Cette sortie est reliée, de préférence connectée, à une borne de commande 212 de l'interrupteur 210 et présente un potentiel OUT de sortie du dispositif 200.

Le dispositif 200 comprend une diode D220 et un élément résistif R230 électriquement en série entre la borne de conduction D1 de l'interrupteur T1 et la borne de commande G1 de l'interrupteur T1. Plus précisément, l'élément résistif R230 et la diode D220 sont connectés directement l'un à l'autre. Dans l'exemple représenté, l'élément résistif R230 est situé entre la diode D220 et la borne de commande G1 de l'interrupteur T1. La diode D220 est donc, dans cet exemple, reliée, de préférence connectée, à la borne de conduction D1, et l'élément résistif R230 est relié, de préférence connecté, à la borne de commande G1.

De préférence, la diode D220 comprend, par exemple est constituée par, un transistor normalement bloqué, plus préférentiellement de type HEMT, encore plus préférentiellement à GaN. Ce transistor est monté en diode, c'est-à-dire qu'il a sa grille reliée, de préférence connectée, à l'une de ses bornes de conductions. Le choix de la borne de conduction reliée à la grille parmi les bornes de source ou drain est à la portée de la personne du métier à partir des propriétés souhaitées de la diode. Dans l'exemple d'un transistor à canal N, la borne de conduction reliée à la grille forme une borne d'anode de la diode, et la borne de conduction non reliée à la grille forme une borne de cathode de la diode.

Une borne 222 de la diode D220 (la cathode dans l'exemple représenté) est tournée vers la borne de commande G1. La borne 222 de la diode D220 est reliée, de préférence par un élément capacitif C250, plus préférentiellement un condensateur, à un nœud 240 d'application d'un potentiel variable V240. La borne 222 de la diode D220 est alors reliée, préférentiellement connectée, à une borne ou électrode 252 de l'élément capacitif C250. Autrement dit, la borne 252 de l'élément capacitif C250 est reliée, de préférence connectée, à un nœud 256. La borne 222 de la diode D220 est reliée, de préférence connectée, au nœud 256. En d'autres mots, le nœud 256 est relié à la borne de commande G1 et est situé du côté de la borne de commande G1 par rapport à la diode D220. Dans l'exemple représenté, le nœud 256 est situé entre la diode D220 et l'élément résistif R230. L'autre borne (borne 254) de l'élément capacitif C250 est reliée, de préférence connectée, au nœud 240.

En fonctionnement, le potentiel V240 est variable par rapport au potentiel de la borne de conduction D1. Autrement dit, la différence entre le potentiel V240 appliqué au nœud 240 et le potentiel de la borne de conduction D1 est variable en fonction du temps. Selon un mode de réalisation, le potentiel du nœud 240 correspond à un signal de commande à appliquer par le dispositif 200 à l'interrupteur 210. De préférence, le potentiel V240 reste inférieur au potentiel de la borne de conduction D1. En particulier, lorsque, dans une cellule de commutation telle que celle de la figure 1, le dispositif 200 remplace le circuit d'attaque 112 ou 114 (figure 1), le potentiel V240 correspond à un signal IN1 formé par le signal respectif SH ou SL (figure 1), ou produit à partir du signal respectif SH ou SL par des circuits non représentés.

Ceci permet de charger l'élément capacitif C250. En effet, lorsque le potentiel appliqué au nœud 240 s'éloigne de celui de la borne de conduction D1, un courant peut passer par la diode D220 pour alimenter l'élément capacitif C250. Lorsque le potentiel appliqué au nœud 240 se rapproche de celui de la borne de conduction D1, le potentiel de la cathode de la diode D220 s'élève au-dessus du potentiel de la borne de conduction D1. Ceci permet alors d'appliquer à la borne de commande G1 du premier interrupteur T1 un potentiel pouvant être supérieur à celui de la borne de conduction D1. Dans l'exemple représenté, ce potentiel est appliqué à la borne de commande G1 via l'élément résistif R230.

De préférence, dans le cas où le premier interrupteur T1 est de type normalement bloqué, l'amplitude des variations du potentiel V240 par rapport au potentiel de la borne de conduction D1 (c'est-à-dire la tension variable entre le nœud 240 et la borne de conduction D1) est supérieure à une tension de seuil du premier interrupteur T1. Par amplitude des variations, on entend l'écart entre des niveaux maximal et minimal, en fonction du temps, de la tension variable entre la borne de conduction D1 et le nœud 240. Dans l'exemple où cette tension (différence de potentiel) est en créneaux, cette amplitude correspond à l'écart entre niveaux haut et bas de la différence de potentiel. Dans le cas où l'interrupteur T1 comprend un transistor à effet de champ, la tension de seuil est définie par la tension entre grille et source pour laquelle un canal de conduction apparaît entre drain et source.

Ainsi, dans le cas où le premier interrupteur T1 est de type normalement bloqué, ceci permet de maintenir l'interrupteur T1 passant en mettant le potentiel appliqué au nœud 240 à un niveau haut. Plus précisément, l'interrupteur T1 est maintenu passant alors que ses bornes de conduction S1 et D1 sont, du fait même que l'interrupteur T1 est passant, au même potentiel ou sensiblement au même potentiel. Ceci permet donc de maintenir l'interrupteur T1 à l'état passant alors que le potentiel de la borne de conduction D1 est inadapté à être appliqué directement à la borne de commande de l'interrupteur T1 pour maintenir l'interrupteur T1 à l'état passant. Ceci est obtenu sans fournir au dispositif 200 de potentiel supérieur à celui de la borne de conduction D1. La seule tension d'alimentation VCC suffit ainsi à alimenter le dispositif 200. La mise en œuvre du dispositif 200 est donc plus simple que celle de dispositifs prévus pour être alimentés par deux tensions d'alimentation.

En variante, l'élément capacitif C250 peut être remplacé par tout dispositif permettant d'appliquer au nœud 256 un potentiel variable temporairement supérieur au potentiel de la borne de conduction D1. La diode D220 permet alors d'alimenter un tel dispositif par un courant lorsque le potentiel appliqué au nœud 256 est inférieur (à une tension de seuil de diode près) au potentiel de la borne de conduction D1.

De préférence, le dispositif 200 comprend en outre des bornes, ou nœuds, 262, 264 de réception par le dispositif 200 d'une tension d'alimentation VCC référencée par rapport à un potentiel REF de la borne 262. La borne de conduction D1 est reliée, de préférence connectée, à la borne 264. Le potentiel REF est de préférence celui d'une borne de conduction de l'interrupteur 210 commandé par le dispositif 200, plus préférentiellement une borne de source de l'interrupteur 210. Ainsi, la borne 262 du dispositif 200 est destinée à être reliée, de préférence connectée, à cette borne de conduction. De préférence, le potentiel V240 du nœud 240 est supérieur au potentiel VREF. Le potentiel V240 varie alors, préférentiellement, entre le potentiel REF et le potentiel de la borne de conduction D1.

La tension d'alimentation VCC peut être fournie au dispositif 200 par un circuit d'alimentation, non représenté. Le circuit d'alimentation peut alors être lui-même alimenté par une tension (tension V, figure 1) aux bornes d'une cellule de commutation telle que la cellule de commutation 100 (figure 1). Le circuit d'alimentation peut également être alimenté par une tension V+ présente aux bornes de l'interrupteur 210. La tension V+ est, de préférence, référencée par rapport au potentiel REF. En variante, le dispositif 200 est alimenté directement par la tension V+, les bornes 262 et 264 étant reliées, de préférence connectées, aux bornes respectives de l'interrupteur 210, de préférence aux bornes respectives de drain et de source de l'interrupteur 210.

De préférence, le dispositif 200 comprend en outre un deuxième interrupteur, T2, reliant la borne de commande G1 du premier interrupteur T1 à la borne 262 d'application du potentiel d'alimentation REF. Le potentiel REF est alors choisi de sorte que son application à la borne de commande G1 du premier interrupteur T1 provoque le blocage de cet interrupteur. Autrement dit, le potentiel REF est un potentiel de blocage de l'interrupteur T1. En fonctionnement, la mise à l'état passant du deuxième interrupteur T2 permet d'appliquer temporairement le potentiel REF à la borne de commande G1 du premier interrupteur T1. A des périodes pendant lesquelles le potentiel de blocage REF n'est pas appliqué à la borne de commande G1, le deuxième interrupteur T2 est alors à l'état bloqué. La mise à un niveau haut du potentiel V240 appliqué au nœud 240 pendant ces périodes rend le premier interrupteur T1 passant, de la manière détaillée ci-dessus.

De préférence, la liaison entre la borne de commande G1 du premier interrupteur T1 et la borne 262 d'application du potentiel de blocage REF comprend seulement le deuxième interrupteur T2, sans autre élément en série tel qu'une résistance (sauf une résistance parasite de l'interrupteur T2 à son état passant). En effet, plus la résistance est faible à l'état passant de l'interrupteur T2 entre la borne de commande G1 et la borne 262, plus le transistor T1 présente l'avantage d'être bloqué rapidement.

L'interrupteur T2 et la borne 262 constituent un dispositif d'application temporaire du potentiel de blocage REF à la borne de commande G1. En variante, ou peut utiliser, à la place de l'interrupteur T2 et de la borne 262, tout dispositif usuel d'application temporaire d'un potentiel de blocage sur une borne de commande d'un interrupteur.

Selon les modes de réalisation décrits, l'élément résistif R230 est passif. Par élément passif, on entend ici que cet élément est destiné à être relié électriquement à des éléments extérieurs à l'élément passif par deux bornes (232 et 234 pour l'élément résistif R230), de préférence uniques, entre lesquelles l'élément passif présente une propriété électrique, telle qu'une résistance, l'élément passif étant dépourvu d'autre borne destinée à être utilisée par un élément extérieur à l'élément passif pour modifier, ou modifier sensiblement, cette propriété électrique. Autrement dit, un tel élément passif ne reçoit, en dehors, éventuellement, d'un courant le traversant de l'une à l'autre des deux bornes et/ou d'une tension entre ces deux bornes, aucun signal, potentiel, ou par exemple, tension d'alimentation susceptible d'influer, ou d'influer sensiblement, sur une relation entre ce courant et cette tension. En particulier, l'élément résistif passif R230 a une valeur de résistance constante ou sensiblement constante, éventuellement à des variations près qui sont seulement fonction de paramètres tels que la température ou le vieillissement. Ainsi, la valeur de résistance est indépendante du niveau bas/haut du potentiel appliqué au nœud 240, autrement dit la valeur de résistance ne varie pas pendant la durée d'une commutation entre niveaux bas/haut du potentiel du nœud 240. Notamment, la liaison entre le nœud 256 et la borne de commande G1 du transistor T1 est passive.

Lorsque le potentiel de blocage REF est appliqué à la borne de commande G1 du premier interrupteur T1 (interrupteur T2 passant), l'élément résistif R230 permet de limiter le courant circulant de la borne 264 à la borne 262 en passant par la diode D220, l'élément résistif R230 et le deuxième interrupteur T2. Dans l'exemple représenté, lorsque le deuxième interrupteur T2 est bloqué, l'élément résistif R230 applique le potentiel du nœud 256 à la borne de commande G1.

De préférence, l'élément résistif R230 est une résistance. L'élément résistif R230 peut également être constitué par tout élément passif permettant de transmettre une tension entre ses bornes en l'absence de courant et de limiter un courant en présence d'une tension à ses bornes. L'élément résistif R230 a, de préférence, une valeur de résistance comprise entre 100 Ω et 100 kΩ, plus préférentiellement entre 1 kΩ et 10 kΩ, par exemple de l'ordre de 3 kΩ. De telles valeurs permettent, pour la plupart des applications, d'optimiser le compromis entre vitesse de mise à l'état passant de le premier interrupteur T1 et consommation de courant lorsque le deuxième interrupteur T2 est à l'état passant. Par exemple, ces valeurs sont particulièrement adaptées au cas où l'interrupteur commandé 210 présente une capacité parasite grille/source comprise entre 20 pF et 2 nF, par exemple de l'ordre de 200 pF. On peut alors choisir l'interrupteur T1 pour obtenir des temps de mise à l'état passant de l'interrupteur 210 inférieurs à 30 ns, par exemple de l'ordre de 5 ns. Plus généralement, l'homme du métier est en mesure de modifier les valeurs décrites ci-dessus pour optimiser ce compromis en fonction de l'application visée.

Lorsque le potentiel V240 est à son niveau haut, la liaison entre le nœud 256 et la borne de commande G1 du transistor T1 est à un potentiel plus élevé que celui des bornes de conduction S1 et D1. Le fait de prévoir que cette liaison soit passive permet, par rapport à une liaison qui comprendrait des composants actifs, d'éviter de fournir une commande à cette liaison. Ceci est particulièrement avantageux dans le cas où les interrupteurs T1 et T2 sont de type HEMT normalement bloqué, car on évite alors d'utiliser un interrupteur de type différent de celui des interrupteurs T1 et T2 et/ou d'utiliser un niveau de potentiel supérieur à celui de la liaison pour commander un état passant. On obtient une mise en œuvre du dispositif 200 plus simple que celle des dispositifs de commande de grille de transistor prévus pour être alimentés par un potentiel supérieur à celui des bornes de conduction S1 et D1, et on bénéficie en même temps de la possibilité de choisir le même type normalement bloqué pour tous les interrupteurs du dispositif 200. Le choix d'interrupteurs d'un même type facilite la fabrication des interrupteurs.

On a ainsi obtenu un dispositif permettant de commander l'état passant/bloqué du premier interrupteur d'une manière particulièrement simple compatible avec l'utilisation uniquement d'interrupteurs d'un même type. De préférence, tous les interrupteurs du dispositif 200 sont de type HEMT normalement bloqué, à savoir, les interrupteurs T1 et T2, et, sauf précision contraire, les éventuels autres interrupteurs du dispositif 200, décrits ci-après.

De préférence, le dispositif 200 est monolithique c'est-à-dire que tous ses circuits sont des circuits intégrés dans et sur un même substrat ou support, typiquement dans et sur une même portion de tranche (en anglais "wafer") semiconductrice. Un tel circuit intégré monolithique est, de préférence, situé dans un boîtier de circuit intégré. Par boîtier de circuit intégré, on entend un ensemble, de préférence étanche, d'où sortent des plages de connexion ou des broches de connexion à des circuits électroniques extérieurs au boîtier, par exemple à un circuit imprimé, PCB (en anglais "Printed Circuit Board"). Par rapport à une variante dans laquelle le dispositif 200 comprend plusieurs composants monolithiques, ceci permet une mise en œuvre plus facile, en particulier pour réaliser une cellule de commutation.

Le fait de prévoir que tous les interrupteurs soient d'un même type permet, par rapport à un dispositif comprenant des interrupteurs de types différents, de rendre possible ou de faciliter la fabrication des interrupteurs sur le même substrat ou support pour réaliser le dispositif monolithique.

Plus préférentiellement, les interrupteurs du dispositif 200 sont du même type que celui de l'interrupteur commandé 210. Le dispositif 200 et l'interrupteur 210 sont alors préférentiellement intégrés dans un même dispositif monolithique. Ceci permet, en particulier, de simplifier la réalisation d'une cellule de commutation telle que celle de la figure 1 dans laquelle les circuits d'attaque 112 et 114 (figure 1) et les interrupteurs IH et IL (figure 1) sont remplacés par de tels dispositifs monolithiques. Ceci permet donc de simplifier la réalisation d'un convertisseur comprenant une telle cellule de commutation. Le dispositif monolithique peut en outre comprendre un ou plusieurs autres dispositifs du type du, ou identiques (à des tolérances de fabrication près) au, dispositif 200. Ces dispositifs sont respectivement reliés, de préférence connectés, à des interrupteurs du type de, ou identiques (à des tolérances de fabrication près) à, l'interrupteur 210. En particulier, on peut prévoir qu'une ou plusieurs cellules de commutation soient situées dans un même dispositif ou composant monolithique.

De préférence, comme dans l'exemple représenté, l'élément résistif R230 est situé entre la diode D220 et la borne de commande G1 du premier interrupteur. Plus précisément, l'élément résistif R230 est situé entre le nœud 256 et la borne de commande G1. Ceci permet, dans les périodes auxquelles l'interrupteur T2 est à l'état passant, de limiter un courant de décharge de l'élément capacitif C250 du nœud 240 à la borne 262. Dans une variante, l'élément résistif R230 et la diode D220 sont en série entre la borne de conduction D1 de l'interrupteur T1 et le nœud 256, le nœud 256 étant relié, de préférence connecté, à la borne de commande G1. Dans cette variante, on peut prévoir tout dispositif permettant de limiter la décharge de l'élément capacitif C250 lorsque le deuxième interrupteur T2 est passant, tel qu'un autre interrupteur compris dans la liaison entre le nœud 240 et l'élément capacitif C250. Cependant par rapport à une telle variante, le fait de prévoir que l'élément résistif R230 soit situé entre la diode D220 et la borne de commande G1 permet de simplifier le dispositif.

Selon une variante de réalisation, une résistance supplémentaire (non représentée) de faible valeur (inférieure à 100 ohms, de préférence inférieure à 10 ohms) est prévue en série avec la diode D220 entre la borne 264 et le nœud 256. Une telle résistance permet de limiter le courant de charge de l'élément capacitif C250.

De préférence, le dispositif 200 comprend en outre un interrupteur T3. L'interrupteur T3 relie la borne de conduction S1 du premier interrupteur T1 à la borne 262 d'application du potentiel REF. De préférence, l'interrupteur T3 est de type HEMT normalement bloqué, plus préférentiellement à GaN. De préférence, l'interrupteur T3 a sa borne de commande reliée, de préférence connectée à la borne de commande G2 du deuxième interrupteur T2. Ainsi, pendant les périodes d'application du potentiel de blocage REF à la borne de commande G1 (interrupteur T2 passant), l'interrupteur T3 est également passant, ce qui permet d'appliquer un niveau bas de commande à l'interrupteur 210, par exemple un niveau de mise à l'état bloqué de l'interrupteur 210. Pendant les périodes auxquelles le potentiel de blocage REF n'est pas appliqué à la borne de commande G1 (interrupteur T2 bloqué), l'interrupteur T3 est également bloqué, ce qui permet, lorsque l'interrupteur T1 est passant, d'appliquer un niveau haut de commande à l'interrupteur 210, par exemple un niveau de mise à l'état passant de l'interrupteur 210.

De préférence, le dispositif 200 comprend en outre un inverseur 290 entre le nœud 240 et la borne de commande du deuxième interrupteur. Dans le présent mode de réalisation, le nœud 240 est relié, de préférence connecté, à l'entrée de l'inverseur 290, et la borne de commande de l'interrupteur T2 est reliée, de préférence connectée, à la sortie de l'inverseur. Ainsi, les potentiels appliqués aux bornes de commandes des différents interrupteurs T1 et T2, ainsi que l'éventuel interrupteur T3, sont générées à partir d'un même signal de commande (tel que les signaux SH ou SL, figure 1) appliqué au nœud 240.

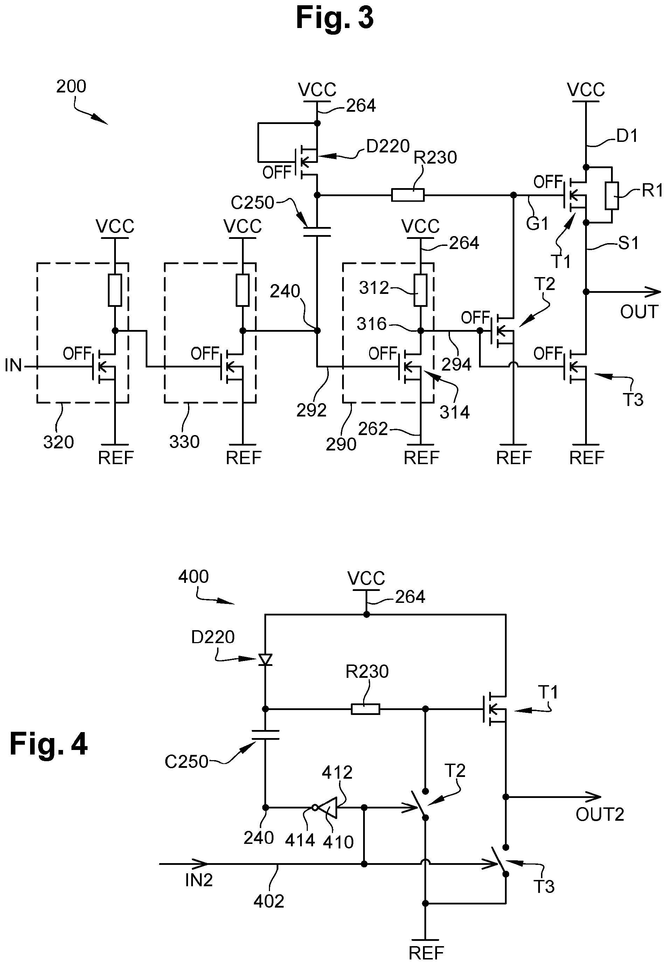

Plus précisément, l'inverseur 290 est différent d'un inverseur comprenant l'interrupteur T1, par exemple un inverseur comprenant l'interrupteur T1 et T3, tel que celui décrit ci-après en relation avec la figure 4. Par rapport à une variante dans laquelle le nœud 240 est relié à la borne de conduction S1, ceci permet, en particulier, de commander l'interrupteur T1 indépendamment de la présence ou de l'absence de l'interrupteur T3, et/ou indépendamment du potentiel de la borne de conduction S1.

Bien que, selon le présent mode de réalisation, le potentiel appliqué au nœud 240, le potentiel de commande de l'interrupteur T2, et éventuellement T3, soient générés à partir du potentiel appliqué au nœud 240 par l'inverseur 290, l'inverseur 290 peut être remplacé par tout circuit adapté à générer, à partir d'un même signal de commande tel que les signaux SH et SL (figure 1), des potentiels variables, préférentiellement inverses l'un de l'autre, sur le nœud 240 et sur la borne de commande G2 de l'interrupteur T2. Des exemples de tels circuits sont décrits ci-après en relation avec les figures suivantes.

La figure 3 représente, de manière schématique mais plus détaillée qu'en figure 2, un exemple de mode de réalisation du dispositif de commande 200 de la figure 2. L'interrupteur 210 (figure 2), extérieur au dispositif 200 n'est pas représenté.

Dans ce mode de réalisation, les interrupteurs T1, T2, et l'éventuel interrupteur T3 sont des interrupteurs de type HEMT normalement bloqué (OFF), de préférence à GaN. La diode D220 est formée par un interrupteur de type HEMT, de préférence à GaN, normalement bloqué, monté en diode. Une résistance R1 peut optionnellement être en parallèle de l'interrupteur T1.

L'inverseur 290 comprend, en série entre les bornes 264 et 262, un élément résistif passif 312, de préférence une résistance, et un interrupteur 314. L'interrupteur 314 est de type HEMT normalement bloqué (OFF), de préférence à GaN. L'élément résistif 312 a une borne reliée, de préférence connectée, à la borne 264, et une autre borne reliée, de préférence connectée, à la borne de drain de l'interrupteur 314. La borne de source de l'interrupteur 314 est reliée, de préférence connectée, à la borne 262. La borne de commande (de grille) de l'interrupteur 314 est reliée, de préférence connectée, à l'entrée 292 de l'inverseur 290, ou constitue l'entrée 292 de l'inverseur 290. Un nœud de connexion 316 entre la borne de drain de l'interrupteur 314 et l'élément résistif 312 est relié, de préférence connecté, à la sortie 294 de l'inverseur 290, ou constitue la sortie 294 de l'inverseur 290. Dans le dispositif 200 obtenu, tous les interrupteurs sont alors de type HEMT normalement bloqué, de préférence à GaN.

A titre d'exemple, le potentiel appliqué au nœud 240 est fourni par deux inverseurs 320 et 330 en série entre une entrée du dispositif 200 recevant un signal IN et le nœud 240. Plus précisément, l'inverseur 320 reçoit le signal IN sur son entrée et l'inverseur 330 reçoit le signal de sortie de l'inverseur 320. L'inverseur 330 a sa sortie reliée, de préférence connectée, au nœud 240 et fournit le potentiel appliqué au nœud 240. Les inverseurs 320 et 330 comprennent des éléments identiques ou similaires à ceux de l'inverseur 290, agencés de manière identique ou similaire. Ces éléments ne sont pas décrits à nouveau.

La figure 4 représente, de manière schématique, un mode de réalisation d'un inverseur 400 recevant un signal d'entrée IN2 et fournissant un signal de sortie OUT2. L'inverseur 400 comprend des éléments identiques ou similaires à ceux du dispositif de commande de grille 200 de la figure 2. Ces éléments ne sont pas décrits à nouveau en détail ci-après. Seules les différences sont mises en exergue.

L'inverseur 400 reçoit le signal d'entrée IN2 sur une entrée 402. A la différence du dispositif 200 de la figure 2, l'entrée 402 est reliée, de préférence connectée, aux bornes de commande des interrupteurs T2 et T3. L'inverseur 400 diffère en outre du dispositif 200 par le fait que l'inverseur 290 a été remplacé par un inverseur 410. L'inverseur 410 a une entrée 412 reliée, de préférence connectée, à l'entrée 402 de l'inverseur 400, et une sortie 414 reliée, de préférence connectée, au nœud 240. Ainsi, l'inverseur 400 et le dispositif 200 différent en ce que leurs inverseurs respectifs 410 et 290 sont en sens opposés.

Selon un mode de réalisation non représenté, un dispositif de commande comprend des éléments identiques ou similaires à ceux de l'inverseur 400, agencés de manière identique ou similaire. Un tel dispositif diffère alors du dispositif 200 de la figure 2 en ce que, pour un même signal d'entrée (IN1 en figure 2, et IN2), les niveaux haut et bas du signal de sortie OUT2 sont inversés par rapport à ceux du signal de sortie OUT du dispositif 200.

Selon un autre mode de réalisation, on prévoit un circuit tampon (en anglais "buffer") comprenant des éléments identiques ou similaires à ceux du dispositif 200 de la figure 2, agencés de manière identique ou similaire. Un tel circuit tampon diffère alors de l'inverseur 400 en ce que, pour un même signal d'entrée, les niveaux haut et bas du signal de sortie OUT sont inversés par rapport à ceux du signal de sortie OUT2 de l'inverseur 400.

De préférence, l'inverseur 410 comprend des éléments identiques ou similaires à ceux de l'exemple de l'inverseur 290 de la figure 3, agencés de manière identique ou similaire. Ces éléments ne sont pas décrits ici à nouveau. De préférence, comme dans le mode de réalisation du dispositif 200 décrit en relation avec la figure 3, tous les interrupteurs de l'inverseur 400 sont de type HEMT normalement bloqué, de préférence à GaN.

Par rapport à l'exemple d'inverseur 290 décrit en relation avec la figure 3, dans l'inverseur 400, lors d'une commutation entre état bas et haut de la sortie, le courant augmente plus rapidement pour un même courant consommé sur la tension d'alimentation VCC. Ceci permet d'accélérer le chargement de capacités parasites de grilles connectées à la sortie de l'inverseur.

De préférence, on remplace, dans le dispositif 200 de commande d'interrupteur de la figure 2, l'inverseur 290 par un inverseur du type de l'inverseur 400 de la figure 4. Ceci permet alors d'accélérer les commutations entre états passant et bloqué et entre états bloqué et passant de l'interrupteur 210 commandé par le dispositif 200 (figure 2).

On peut également remplacer, dans l'inverseur 400 de la figure 4, l'inverseur 410 par un inverseur du type de l'inverseur 400. Ceci permet une accélération supplémentaire d'un circuit utilisant cet inverseur 400, par exemple un dispositif du type du dispositif 200 dans lequel l'inverseur 290 est remplacé par cet inverseur 400 comprenant un inverseur du type de l'inverseur 400 de la figure 4.

De même, dans l'inverseur du type de l'inverseur 400 remplaçant l'inverseur 410 dans un inverseur 400, on peut à nouveau remplacer l'inverseur 410 par autre inverseur du type de l'inverseur 400. On peut encore remplacer l'inverseur 410, et ainsi de suite, de manière récursive. Le nombre de remplacements successifs d'un inverseur 410 par un inverseur du type de l'inverseur 400 (c'est-à-dire la profondeur de récursion), est par exemple supérieur ou égal à 2, 3 ou 4.

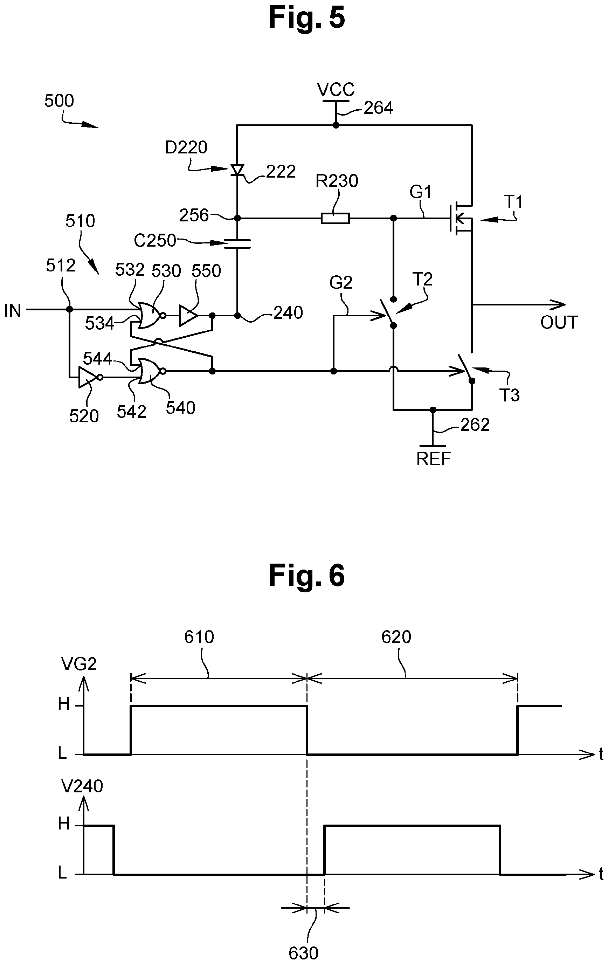

La figure 5 représente, de manière très schématique, un autre mode de réalisation d'un dispositif de commande 500 d'un interrupteur non représenté. Le dispositif 500 comprend des éléments identiques ou similaires à ceux du dispositif 200 de la figure 2, agencés de manière identique ou similaire. Seules les différences sont mises en exergue ci-après.

Le dispositif 500 de la figure 5 diffère de celui de la figure 2 en ce que l'inverseur 290 (figure 2) a été remplacé par un circuit logique 510. Le circuit 510 est adapté à générer à partir d'un signal IN des potentiels variables différents sur le nœud 240 et sur la borne de commande G2 de l'interrupteur T2. Le signal IN est un signal correspondant à la commande à appliquer à l'interrupteur commandé par le circuit 500. Le signal IN correspond par exemple à l'un des signaux SH et SL décrits en relation avec la figure 1.

Le circuit 510 reçoit le signal IN sur une entrée 512. Le circuit 510 comprend un inverseur 520 ayant une entrée reliée, de préférence connectée, à l'entrée 512. Le circuit 510 comprend une porte logique NON OU 530 ayant une entrée 532 reliée, de préférence connectée, à l'entrée 512. Le circuit 510 comprend une porte logique NON OU 540 ayant une entrée 542 reliée, de préférence connectée, à la sortie de l'inverseur 520. La porte logique 540 a sa sortie reliée, de préférence connectée, à une entrée 534 de la porte logique 530. Le circuit 510 comprend un circuit tampon 550 (en anglais "buffer") ayant une entrée reliée, de préférence connectée, à la sortie de la porte logique 530. Le circuit tampon 550 a sa sortie reliée à une entrée 544 de la porte logique 540. La sortie du circuit tampon 550 est reliée, de préférence connectée, au nœud 240. La sortie de la porte logique 540 est reliée, de préférence connectée, à la borne de commande G2 de l'interrupteur T2.

La figure 6 représente, par des chronogrammes schématiques, le fonctionnement du dispositif 500 de la figure 5. Plus précisément, on a représenté en fonction du temps t des allures du potentiel V240 appliqué au nœud 240 et du potentiel VG2 appliqué à la borne de commande G2 de l'interrupteur T2.

Le signal IN (figure 5) est de préférence en créneaux. Chacun des potentiels V240 et VG2 fournis par le circuit 510 est également en créneaux entre des niveaux bas (L) et haut (H) à la même fréquence que celle du signal IN. Ainsi, dans le cas où le dispositif 500 est utilisé pour commander un interrupteur d'une cellule de commutation telle que celle de la figure 1, cette fréquence est la fréquence de découpage. Le potentiel VG2 est alternativement à son niveau haut pendant des périodes 610 et à son niveau bas pendant des périodes 620. Les périodes 610 et 620 sont ainsi des périodes respectivement d'application et de non-application du potentiel de blocage REF à la borne de commande G1 du premier interrupteur T1.

Le potentiel V240 est à son niveau haut au cours des périodes 620, plus précisément au cours d'une partie de chaque période 620. Du fait que le potentiel de blocage REF n'est pas appliqué à la grille de commande G1, ceci met le premier interrupteur T1 à l'état passant.

Le potentiel V240 est à son niveau bas pendant des périodes 610 auxquelles le deuxième interrupteur T2 est à l'état passant. Le niveau bas du potentiel V240 est choisi pour provoquer le blocage du premier interrupteur. Dans le cas préféré où le nœud 240 est relié à la borne 222 de la diode D220 par l'élément capacitif C250, et où le premier interrupteur est de type normalement bloqué, le niveau bas du potentiel V240 provoque ce blocage quel que soit le niveau bas du potentiel en créneaux V240.

A des périodes 630 situées au début et à la fin de chaque période 620, le potentiel V240 est également à son niveau bas, provoquant le blocage du premier interrupteur T1.

Dans le cas préféré où la borne de commande G2 du deuxième interrupteur T2 est reliée ou connectée à la borne de commande de l'interrupteur T3, l'interrupteur T3 est alors respectivement bloqué et passant pendant les périodes respectives 620 et 610. Le circuit 510, et en particulier le retard induit par le circuit tampon 550 entre son entrée et sa sortie, sont choisis en fonction des divers temps de réaction des interrupteurs T1, T2 et T3. Ce choix est de sorte que l'interrupteur T1 soit passant seulement pendant les périodes 620 où l'interrupteur T3 est bloqué, et de sorte que le premier interrupteur T1 est à l'état bloqué pendant l'intégralité des période 610 auxquelles l'interrupteur T3 est passant. Un tel choix est à la portée de la personne du métier à partir des indications fonctionnelles ci-dessus. On garantit ainsi l'absence de mise en court-circuit par les interrupteurs T1 et T3 des bornes d'alimentation 264 et 262.

Divers modes de réalisation et variantes ont été décrits. La personne du métier comprendra que certaines caractéristiques de ces divers modes de réalisation et variantes pourraient être combinées, et d'autres variantes apparaitront à la personne du métier. En particulier, on a décrit, en relation avec la figure 2, un nœud 256 relié ou connecté à la diode D220 et situé, par rapport à la diode D220, du côté de la borne de commande G1. Le circuit 510 de la figure 5 et l'élément capacitif C250 peuvent alors être remplacés par tout circuit configuré pour fournir des potentiels variables sur la borne de commande G2 et sur ce nœud 256. Ces potentiels variables peuvent présenter des variations identiques ou similaires à celles des potentiels VG2 et V240 décrits en relation avec la figure 6.

Les modes de réalisation ne se limitent pas à des dispositifs de commande d'interrupteur, tels que les dispositifs 200 (figure 2) et 500 (figure 5), et à des inverseurs tels que l'inverseur 400 (figure 4). Dans le cas où l'interrupteur T3 est omis, un dispositif tel que les dispositifs 200, 400 et 500 décrits ci-dessus peut être utilisé pour commander tout transistor à effet de champ à canal N ayant son potentiel de drain à un niveau haut de potentiel d'alimentation, ce transistor étant de préférence de type normalement bloqué. En particulier, l'inverseur 400 est un exemple non limitatif de circuit logique. Chaque transistor à canal P de circuits logiques usuels peut être remplacé par le premier interrupteur T1 à canal N d'un dispositif du type des dispositifs 200, 400 et/ou 500 dépourvu de l'interrupteur T3. Ceci est particulièrement avantageux pour réaliser des circuits logiques uniquement à partir de transistors de type HEMT, de préférence à GaN.

Bien que, dans des modes de réalisation décrits ci-dessus, des interrupteurs de type HEMT à canal N soient décrits, la personne du métier pourra adapter ces modes de réalisation à d'autres types de transistors, par exemple à canal P et de préférence normalement bloqués, en inversant l'anode et la cathode de la diode D220 et les signes des tensions.

Enfin, la mise en œuvre pratique des modes de réalisation et variantes décrits est à la portée de la personne du métier à partir des indications fonctionnelles données ci-dessus.

## Revendications

1. Dispositif (200 ; 400 ; 500) comprenant un premier interrupteur (T1) formé d'un transistor à effet de champ, une diode (D220) et un premier élément résistif passif (R230) électriquement en série entre un drain (D1) et une grille (G1) du premier interrupteur, ledit drain et une anode de la diode étant connectés à une borne (264) d'application d'un premier potentiel d'une tension d'alimentation (VCC) référencée à un deuxième potentiel, et une cathode (222) de la diode étant reliée, par un élément capacitif (C250), à un nœud (240) d'application d'un potentiel variable par rapport audit premier potentiel et supérieur audit deuxième potentiel.

2. Dispositif selon la revendication 1, dans lequel ledit potentiel variable correspond à un signal en créneaux variant entre les premier et deuxième potentiels.

3. Dispositif selon la revendication 1 ou 2, dans lequel le premier interrupteur (T1) est de type HEMT, de préférence à GaN.

4. Dispositif selon l'une quelconque des revendications 1 à 3, dans lequel le premier élément résistif (R230) est situé entre ladite cathode (222) de la diode (D220) et ladite grille (G1).

5. Dispositif selon l'une quelconque des revendications 1 à 4, comprenant en outre, en série avec le premier interrupteur (T1), un interrupteur supplémentaire (T3), de préférence de type HEMT.

6. Dispositif selon l'une quelconque des revendications 1 à 5, dans lequel un premier état (REF) du potentiel variable engendre l'application à ladite borne de commande (G1), un potentiel de blocage (REF) du premier interrupteur (T1).

7. Dispositif selon la revendication 6, dans lequel, à des premières périodes (620) de non application du potentiel de blocage (REF), ledit potentiel variable (V240) est à un niveau engendrant une mise à l'état passant du premier interrupteur (T1).

8. Dispositif selon la revendication 7, dans lequel le potentiel variable (240) est à un niveau de blocage du premier interrupteur pendant des deuxièmes périodes (610) d'application du potentiel de blocage et pendant des troisièmes périodes (630) situées au début et à la fin de chaque première période (620).

9. Dispositif selon l'une quelconque des revendications 6 à 8, comprenant un inverseur (290 ; 410) reliant ledit nœud (240) à une borne de commande (G2) d'un deuxième interrupteur (T2) configuré pour appliquer le potentiel de blocage (REF) à la borne de commande (G1) du premier interrupteur (T1), le deuxième interrupteur étant de préférence de type HEMT.

10. Dispositif selon la revendication 9, dans lequel l'inverseur (290 ; 410) comprend un autre élément résistif passif (312) et un troisième interrupteur (314) en série, une entrée (292) reliée à la grille du troisième interrupteur, et une sortie (294) reliée à un nœud de connexion entre ledit transistor et ledit autre élément résistif, le troisième interrupteur étant de préférence de type HEMT.

11. Dispositif selon l'une quelconque des revendications 1 à 10, comportant une deuxième résistance en série avec ladite diode (D220) entre ladite borne (264) d'application du premier potentiel et un nœud (256) entre le premier élément résistif (R230) et ledit élément capacitif (C250).

12. Inverseur (400) comprenant un dispositif selon l'une quelconque des revendications 1 à 10.

13. Dispositif selon la revendication 9 ou 10, dans lequel l'inverseur est un inverseur selon la revendication 11.

14. Circuit (200 ; 500) de commande d'un interrupteur commandé (210), comprenant un dispositif selon l'une quelconque des revendications 1 à 10, ou 12, ledit interrupteur commandé comprenant, de préférence, un ou des transistors de type HEMT.

15. Circuit monolithique comprenant un dispositif selon l'une quelconque des revendications 1 à 10, ou 12, ou comprenant un circuit selon la revendication 13 comprenant, de préférence, ledit interrupteur commandé.

16. Convertisseur à découpage comprenant un ou plusieurs dispositifs selon l'une quelconque des revendications 1 à 10, ou 12, ou comprenant un circuit selon la revendication 13 ou 14.
